# EUROPÄISCHE PATENTSCHRIFT

(11) **EP 0 495 360 B1**
(45) Veröffentlichungstag und Bekanntmachung des Hinweises auf die Patenterteilung: **21.04.1999**
(21) Anmeldenummer: 92100088.1
(22) Anmeldetag: 04.01.1992
(51) Int. Cl.: H04M 9/08, H04M 1/60, H03G 3/32

(54) **Anordnung zur Lautstärkeeinstellung bei einer Freisprecheinrichtung**
Arrangement for volume control in a hands free telephone device
Disposition pour commande de volume dans une dispositif téléphonique mains libres

(30) Priorität: 15.01.1991 DE 4100985
(43) Veröffentlichungstag der Anmeldung: 22.07.1992
(73) Patentinhaber: AEG MOBILE COMMUNICATION GmbH, D-89081 Ulm (DE)
(72) Erfinder: Fritz, Werner, Dipl.-Ing. (FH), W-7910 Neu-Ulm 4 (DE)
(74) Vertreter: Körner, Ekkehard, Dipl.-Ing.

(56) Entgegenhaltungen:
- DE-A- 3 426 815
- US-A- 4 829 565
- PATENT ABSTRACTS OF JAPAN vol. 7, no. 255 (E-210)12. November 1983 & JP-A-58 141 067 (AIHON KK) 22. August 1983
- TELCOM REPORT SIEMENS Bd. 12, Nr. 3 , Mai 1989 , MUNCHEN DE Seiten 90 - 93 XP52796 W. KRAFFT 'Digitales Freisprechen: ISDN-Komfort freihändig nutzen'
- ICCE 85 -IEEE INTERNATIONAL CONFERENCE ON CONSUMER ELECTRONICS (85CH2192) -SESSION XIX -FAM19.1 Juni 1985 Seiten 266 - 267 G.KLOESZ ET AL. 'Hands-free telephone conversations are simplified using new integrated circuits'
- ELEKTRONIK, vol., no.22, 30.10.1987, page 87 - 90, ING.CHANDRA DESAI 'FREI SPRECHEN OHNE RüCKKOPPLUNG'

## Beschreibung

Die Erfindung betrifft eine Anordnung zur Lautstärkeeinstellung bei einer Freisprecheinrichtung nach dem Oberbegriff des Patentanspruchs 1. Eine solche Anordnung ist aus der Zeitschrift Elektronik, Heft 22, Oktober 1987, Seiten 87 bis 90 bekannt.

Analog oder digital arbeitende Freisprecheinrichtungen sind gebräuchlich bei Auto-, Funk- oder Drahttelefonen. Im Gegensatz zum Lauthören braucht bei Einsatz einer Freisprecheinrichtung zum Telefonieren der Handapparat nicht mehr abgenommen zu werden. Um dieses Problem technisch in den Griff zu bekommen, sind Bausteine speziell für diesen Zweck entwickelt worden. In der vorgenannten Zeitschrift wird ein solcher Freisprechbaustein MC 34018 beschrieben, bei dem die Lautstärke, mit der empfangene Gespräche über einen Lautsprecher wiedergegeben werden können, nach Wunsch individuell über ein Bedienelement, zum Beispiel ein Potentiometer, eingestellt werden kann. Eine mit dem Potentiometer variabel einstellbare Spannung liegt an einem Lautstärkesteuereingang des Freisprechbausteins. Es hat sich jedoch gezeigt, daß bei wechselndem Umgebungsgeräuschpegel die mit dem Potentiometer eingestellte Lautstärke nicht immer angemessen ist.

Aus der DE 34 26 815 A1 ist bekannt, die Lautstärke bei einem Freisprechtelefon unter Berücksichtigung von ankommendem Signal und jeweiligem Raumgeräusch zu regeln. Hierzu sind alle relevanten Signale einem Mikroprozessor zugeführt, der variable Dämpfungsglieder in Sende- und Empfangssignalpfad steuert. Die Mikroprozessorsteuerung ermöglicht zwar eine flexible Funktionsweise, führt durch die zahlreichen erforderlichen Peripheriebaugruppen und entsprechende Software aber zu einer umfangreichen und dadurch nachteiligen Anordnung.

Aus Patent Abstract of Japan, Vol. 7 Nr. 255 (E-210) vom 12.11.1983 und JP-A-58/141,067 vom 22. August 1983 ist eine automatische Lautstärkesteuereinrichtung für eine Gegensprechanlage bekannt, mit der die Wiedergabelautstärke in Abhängigkeit vom Umgebungsgeräuschpegel und Benutzerbedingungen auf einen optimalen Pegel eingestellt werden kann. In der vorgestellten Schaltung wird das Hintergrundgeräusch mittels eines Mikrofons erfaßt, und in einer Trennschaltung wird das Hintergrundgeräusch von dem vom selben Mikrofon erfaßten Empfangsnutzsignal abgetrennt und zur Beeinflussung eines Lautstärkesteuerkreises im Empfangspfad verwendet.

Aus der US-A-4 829 565 ist ein Telefonapparat bekannt, von dem mittels eines im Handapparat rückseitig zum Hörer installierten Mikrofons der Umgebungsgeräuschpegel erfaßt und für die Steuerung der Wiedergabelautstärke verwendet wird. Ein Lautsprecherbetrieb oder Freisprechen ist bei diesem Telefonapparat weder vorgesehen noch möglich, da Einrichtungen fehlen, mit denen eine Selbsterregung aufgrund akustischer Rückkopplung vermieden werden könnte.

Der Erfindung liegt die Aufgabe zugrunde, eine vorteilhafte Anordnung für eine Lautstärkeeinstellung in einer Freisprecheinrichtung bei variierenden Hintergrundgeräuschpegeln anzugeben.

Diese Aufgabe wird durch die im Anspruch 1 angegebenen Merkmale gelöst. Vorteilhafte Ausgestaltungen und Weiterbildungen der Erfindung sind Gegenstand der Unteransprüche.

Wesentlich an der vorliegenden Erfindung ist, daß auf bewährte Schaltungen von Freisprechbausteinen gebräuchlicher Art zurückgegriffen werden kann. Bei Einsatz von handelsüblichen Freisprech-Bausteinen wird mit geringer Zusatzbeschaltung eine sich in der Praxis sehr gut bewährende Lautstärkenachführung erreicht. Besonders vorteilhaft ist die Ausnutzung von am Freisprech-Baustein abgreifbaren Signalen eines mitintegrierten Signal/Rauschdetektors, der ein hintergrundgeräuschabhängiges Signal abgibt. Dies ist z.B. möglich bei dem bereits erwähnten Baustein MC 34018 oder dem U 4080 B. Bei verwandten Freisprech-Bausteinen, die zwar gleichfalls mindestens einen integrierten Signal/Rauschdetektor im Mikrofonsignalweg enthalten, dessen Signal aber nicht vollständig an Anschlüsse des Freisprech-Bausteins herausgeführt werden, wie z.B. bei den Freisprech-Bausteinen MC 34118, TEA 7540, PBM 3912 oder PSB 45030, kann ein solcher Signal/Rauschdetektor mit einfachen Mittel ganz oder teilweise extern aufgebaut und die gewünschte hintergrundgeräuschabhängige Nachführspannung aus einem zugeführten Mikrofonsignal geleitet werden. Die Erfindung kann auch vorteilhaft durch geringfügige Ergänzung bekannter Schaltungen in einen Freisprech-Baustein ganz oder teilweise integriert werden.

Die Nachführspannung als ein Maß für den Pegel von Hinter-grundgeräuschen wird vorzugsweise in Gesprächspausen gewonnen, die in an sich bekannter Weise aus einem Mikrofonsignal ermittelbar sind. Die automatische Nachführung der Lautstärke kann manuell oder automatisch abschaltbar sein. Vorteilhaft ist insbesondere die automatische Abschaltung der Nachführung bei starkem Empfangsrauschen oder störenden Empfangs-NF-Signalen. Dabei kann auch die Nachführspannung und somit die Verstärkung des Empfangskanals gespeichert werden, bis sich die Verhältnisse wieder gebessert haben.

Die Erfindung ist nachfolgend an einem Ausführungsbeispiel unter Bezugnahme auf die Abbildungen noch eingehend veranschaulicht, wobei für den Freisprech-Baustein der bereits genannte MC 34018 zugrunde gelegt ist.

In FIG. 1 ist das Blockschaltbild für eine erfindungsgemäße Anordnung dargestellt.

In FIG. 2 sind einige Signalverläufe in einem Zeit/Spannungsdiagramm dargestellt.

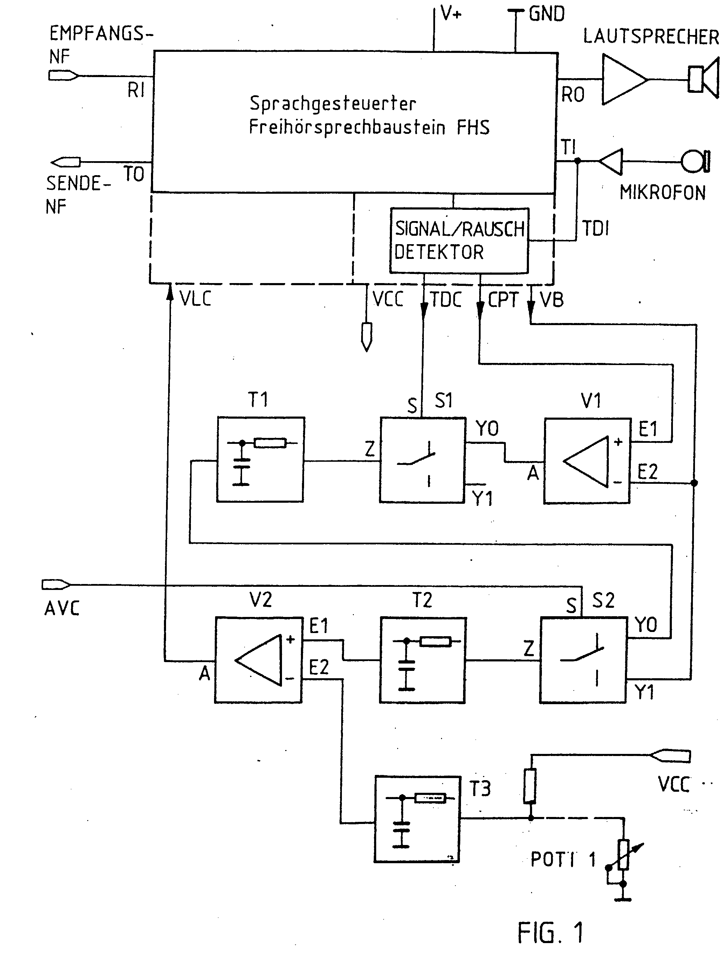

Die Funktion des Freisprechbausteins FHS ist bekannt und wird deshalb nicht gesondert behandelt. Gemäß FIG. 1 liegt an den Eingängen TI und TDI des Freisprechbausteins FHS mit integriertem Signal/Rauschdetektor die zu sendende vorverstärkte Mikrofonspannung, die nach Durchlaufen des Bausteins FHS am Ausgang TO des Sendesignalabschwächers abgegriffen wird (Sende-NF). Die Empfangs-NF liegt an dem Eingang RI des Bausteins FHS und wird nach Durchlaufen des Bausteins FHS, am Ausgang RO des Empfangssignalabschwächers abgegriffen, von wo sie über einen NF-Verstärker dem Lautsprecher zugeführt wird. Die unterbrochenen Linien sollen andeuten, daß bei nicht aus dem Baustein FHS herausgeführten Anschlüssen TDC und CPT der Signal/Rauschdetektor extern aufgebaut ist.

Das Signal am Anschluß CPT wird vom Freisprechbaustein FHS einem Differenzverstärker V1 (Eingang E1) zugeführt. Dieses Signal enthält in den Sprechpausen einen dem Umgebungsgeräusch proportionalen Spannungsanteil, der durch Bildung der Differenz zur Referenzspannung am Anschluß VB (Eingang E2 des Verstärkers V1) mittels des Verstärkers V1 am Ausgang A desselben gewonnen und einem ersten elektronischen Schalter S1 an dessen Eingang YO zugeführt wird.

Das Ausgangssignal eines Mikrofonsignal/Rauschdetektors am Anschluß TDC nimmt bei Sprache den logischen Zustand HIGH an und läuft in den Sprechpausen gegen den logischen Zustand LOW. Dieses Signal schaltet nun den ersten elektronischen Schalter S1, dessen Steuereingang S beispielsweise eine Schaltschwelle mit Hysterese aufweisen kann, zwischen Eingang YO und Ausgang Z durch, wenn es sich im Zustand LOW befindet. Die Spannung am Ausgang Z Iadt dann einen ersten Analogspeicher T1 mit einer Ladezeitkonstante von beispielsweise ca. 50ms.
Die in die Zeichnung eingetragenen Anschlüsse TI, TDI, CPT, TDC und VLC entsprechen den in dem genannten "Elektronik"-Artikel, Bild 2 gebrauchten Bezeichnungen TXI, XDI, CP1, XDC und ULC. Der Mikrofonverstärker und/oder die Lautsprecher-Endstufe können abweichend von der Skizze nach FIG. 1 im Baustein FHS integriert sein.

Steht ein von einem Steuerprozessor (nicht dargestellt) kommendes Schaltsignal AVC auf logisch HIGH, so ist die Lautstärkeautomatik nicht aktiv. In diesem Fall gelangt die Referenzspannung von VB über einen zweiten elektronischen Schalter S2 (Eingang Y1, Ausgang Z) zu einem zweiten Analogspeicher T2 mit einer Ladezeitkonstante von ca. 1s und von dort zum Eingang E1 eines Summierverstärkers V2. Die Stellgröße VLC für die Lautstärke, die vom Summierverstärker V2 (Ausgang A) zum Freihörsprechbaustein FHS gelangt, wird in diesem manuellen Betriebsfall nur von der Stellung eines Potentiometers POTI 1 bestimmt. Die über das Potentiometer POTI 1 erzeugte Spannung gelangt über einen Tiefpaß T3 zum Eingang E2 des Summierverstärkers V2.

Steht das vom Steuerprozessor kommende Schaltsignal AVC auf logisch LOW, so ist die Lautstärkeautomatik aktiv. In diesem Fall gelangt der über TDC und CPT gewonnene Signalpegel über den zweiten Schalter S2 (Eingang YO, Ausgang Z) zum zweiten Analogspeicher T2 mit der Ladezeitkonstante von beispielsweise ca. 1s und von dort zum Eingang E1 des Summierverstärkers V2. Im zweiten Analogspeicher T2 erfolgt die Mittelwertbildung des in den Sprechpausen gewonnenen Signals, das im ersten Analogspeicher T1 zwischengespeichert wird.

Die Stellgröße VLC für die Lautstärke, die vom Summierverstärker V2 (Ausgang A) zum Freisprechbaustein FHS gelangt, wird in diesem Automatik-Betriebsfall von der Spannung des Potentiometers POTI 1 und von der hintergrundgeräuschabhängigen Nachführspannung am Summierverstärker V2 (Eingang E1) bestimmt. Je nach Art der Gewinnung der Grundspannung und der Nachführspannung kann die Zusammenfassung im Summierverstärker V2 variieren, wobei jeweils zu beachten ist, daß eine Erhöhung des Geräuschpegels eine Erhöhung der Lautstärke bewirken soll.

Mit dem Potentiometer POTI 1 wird die Grundlautstärke eingestellt. Die Analogspeicher T1, T2 dienen der Signalglättung und halten die Geräusch-Referenzspannung, während gesprochen wird. Sie verhindern gleichzeitig einen Einfluß kurzzeitiger Störgrößen.

Um den Komfort und die Stabilität des Systems zu erweitern, können weitere Einrichtungen vorgesehen sein. Beispielsweise schaltet ein dem Freisprechbaustein FHS vorgeschalteter Signalprozessor, der laufend das Signal/Rausch-Verhältnis der Empfangs-NF mittelt, über das Steuersignal AVC bei schlechtem Signal/Rausch-Verhältnis die Automatik ab, so daß die Lautstärke nur noch manuell geändert werden kann, bis das Signal/Rausch-Verhältnis wieder besser ist.

Eine weitere Möglichkeit bietet eine Hardware zur Rausch-und Störpegel-Erkennung im Empfangskanal (funktionsgleich der erfindungsgemäßen Schaltung für die Hintergrundgeräuscherkennung), die aber in diesem Fall die Automatik so lange abschaltet, bis wieder bessere Bedingungen existieren.

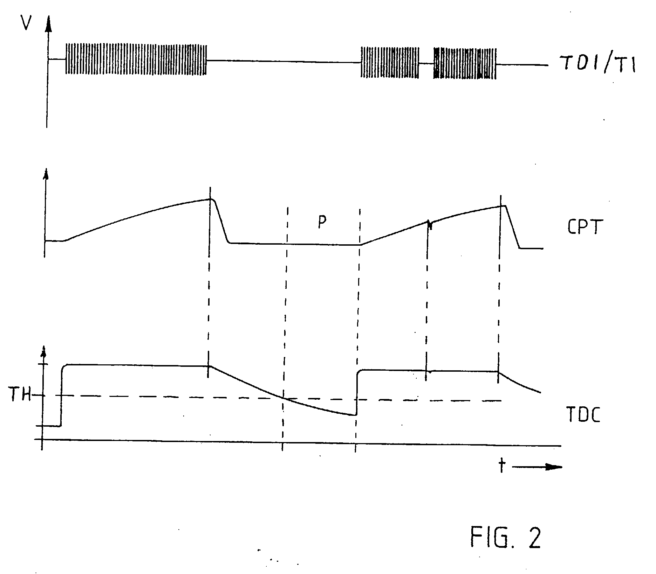

Bei den in FIG. 2 skizzierten Signalverläufen sind das am Anschluß TDI anliegende, ggf. verstärkte Mikrofonsignal, das am Anschluß CPT abgreifbare Signal, sowie das Ausgangssignal des Signal/Rauschdetektors am Anschluß TDC als Spannungen V über der Zeit t aufgetragen..

Im Mikrofonsignal sind die Sprachsignale, die in diesem Falle die Nutzsignale bilden als charakteristische Signalblöcke eingezeichnet. Die Umgebungsgeräusche sind nicht mit dargestellt. Die für die Erläuterung der Erfindung maßgebliche Wirkungsweise des Signal/Rauschdetektors ist derart, daß während eines Sprachblocks das Signal an CPT langsam ansteigt und nach Wegfall des Sprachsignals mit kürzerer Zeitkonstante abfällt auf einen Wert, der den dann noch vorhandenen Hintergrundgeräuschpegel enthält. Im Gegensatz dazu springt das Ausgangssignal an TDC bei Auftreten eines Sprachsignals auf einen Wert, der bezüglich einer Schaltschwelle TH evtl mit Hysterese, z.B. des Schalters S1, als logisch HIGH bezeichnet sei, und fällt nach Ende des Sprachsignals langsam ab. Ein Unterschreiten der Schwelle sei als Übergang in den Signal-Schaltzustand LOW bezeichnet. Sehr kurze Sprechpausen, wie zwischen den beiden kürzeren Sprachblöcken, wirken nur gering auf die Signale an CPT und TDC und lassen insbesondere den Schaltzustand unbeeinflußt. In längeren Sprechpausen geht das Signal an TDC verzögert in den logischen Zustand LOW und verharrt dort für ein Pausenintervall P. Durch die unterschiedlichen Abfallzeiten der Signale an CPT und TDC ist sichergestellt, daß während des Intervalls P keine Nutzsprachanteile im Mikrofonsignal bzw. dem daraus abgeleiteten Signal an CPT enthalten sind. In diesem Zeitintervall stellt somit das Signal an CPT ein Maß für den Pegel der Hintergrundgeräusche dar und wird zur Gewinnung der Nachführspannung ausgewertet.

Die Referenzspannung an VB ist im Beispiel gemäß FIG. 2 im Baustein FHS erzeugt. Durch Bezug der Nachführspannung auf diese Referenzspannung können Bauteilunterschiede und Temperatureinflüsse kompensiert werden. Die Referenzspannung kann auch extern erzeugt werden, z.B. wenn der Signal/Rausch-Detektor separat realisiert ist.

Die vorstehend beschriebenen Schaltungsteile zur Gewinnung der geräuschabhängigen Nachführspannung können auch teilweise oder vollständig in einem neu zu gestaltenden Baustein FHS mit integriert sein, wobei dann hierfür nur geringfügige Ergänzungen bewährter Schaltungen notwendig sein. Am Lautstärkersteuereingang eines solchen Bausteins FHS liegt dann beispielsweise nur die am Potentiometer eingestellte Spannung an, und die Verknüpfung mit der bausteinintern erzeugten Nachführspannung erfolgt im Baustein FHS.

## Patentansprüche

1. Anordnung zur Lautstärkeeinstellung in einer Freisprecheinrichtung, enthaltend einen integrierten Freisprechbaustein (FHS), der steuerbare Mittel zur veränderlichen Einstellung der Wiedergabe-Lautstärke des Empfangssignals RI nach Maßgabe einer mittels eines Bedienelements (POTI1) einstellbaren Steuerspannung (VLC) aufweist, und wobei ein Signal/Rauschdetektor zur Gewinnung einer hintergrundgeräuschabhängigen Nachführspannung in Sprechpausen vorgesehen ist, dadurch gekennzeichnet, daß eine Signalverknüpfungseinrichtung (V2) vorhanden ist, die aus einer mittels des Bedienelements (POTI1) eingestellten Grundspannung und der in Analogspeichereinrichtungen (T1, T2) geglätteten Nachführspannung die Steuerspannung (VLC) für die steuerbaren Mittel erzeugt.

2. Anordnung nach Anspruch 1, dadurch gekennzeichnet, daß der Signal/Rauschdetektor in dem Freisprechbaustein (FHS) realisiert ist und ein Ausgangssignal, das eine Information über Gesprächspausen enthält, sowie ein Vergleichssignal, das in Gesprächspausen ein Maß für den Hintergrundgeräuschpegel ist, an Anschlüssen des Freisprechbausteins (FHS) abgreifbar sind.

3. Anordnung nach Anspruch 1, dadurch gekennzeichnet, daß der Signal/Rauschdetektor getrennt von dem Freisprechbaustein (FHS) vorgesehen ist und diesem Signal/Rauschdetektor ein Mikrofonsignal zugeführt ist.

4. Anordnung nach Anspruch 1, dadurch gekennzeichnet, daß die Mittel zur Gewinnung der Nachführspannung (VLC) und/oder die Signalverknüpfungseinrichtung teilweise oder vollständig in den Freisprechbaustein (FHS) integriert sind.

5. Anordnung nach einem der vorangehenden Ansprüche, dadurch gekennzeichnet, daß die Nachführspannung auf eine im Freisprechbaustein (FHS) erzeugte Referenzspannung (an VB) bezogen ist.

6. Anordnung nach einem der vorangehenden Ansprüche, dadurch gekennzeichnet, daß die automatische Nachführung abschaltbar ist.

7. Anordnung nach Anspruch 6, dadurch gekennzeichnet, daß bei Abschaltung der automatischen Nachführung die Nachführspannung speicherbar ist.

8. Anordnung nach Anspruch 6, dadurch gekennzeichnet, daß bei der Abschaltung der automatischen Nachführung die Steuerspannung nur noch von der Grundspannung abhängig ist.

9. Anordnung nach einem der Ansprüche 6 bis 8, dadurch gekennzeichnet, daß die Abschaltung automatisch steuerbar ist.

## Claims

1. An arrangement for volume adjustment in a handsfree device, including an integrated handsfree component (FHS) comprising controllable means for variable adjustment of the playback volume of the receiver signal RI in accordance with a control voltage (VLC) adjustable by means of an operating element (POTI1), and wherein a signal/noise detector for obtaining a background noise-dependent tracking voltage during conversation breaks is provided, characterized in that a signal linking means (V2) is provided which generates the control voltage (VLC) for the controllable means from a base voltage adjusted by means of the operating element (POTI1) and the tracking voltage smoothened in the analog memory means (T1, T2).

2. An arrangement as claimed in claim 1, characterized in that the signal/noise detector is realized in the handsfree component (FHS) and an output signal containing information on conversation breaks as well as a comparison signal which during conversation breaks is a measure for the background noise level, can be tapped at terminals of the handsfree component (FHS).

3. An arrangement as claimed in claim 1, characterized in that the signal/noise detector is provided separate from the handsfree component (FHS) and a microphone signal is supplied to this signal/noise detector.

4. An arrangement as claimed in claim 1, characterized in that the means for obtaining the tracking voltage (VLC) and/or the signal linking means are integrated partially or completely into the handsfree component (FHS).

5. An arrangement as claimed in one of the preceding claims, characterized in that the tracking voltage is related to a reference voltage (at VB) generated in the handsfree component (FHS).

6. An arrangement as claimed in one of the preceding claims, characterized in that the automatic tracking can be switched off.

7. An arrangement as claimed in claim 6, characterized in that the tracking voltage is storable in the turn-off of the automatic tracking.

8. An arrangement as claimed in claim 6, characterized in that the control voltage depends on the base voltage only when turning off the automatic tracking.

9. An arrangement as claimed in one of claims 6 to 8, characterized in that the turn-off is controllable automatically.

## Revendications

1. Agencement permettant d'ajuster l'intensité sonore dans un dispositif vocal mains libres, contenant un bloc fonctionnel vocal mains libres (FHS) intégré qui comprend un moyen pouvant être commandé servant à ajuster d'une manière variable l'intensité sonore de restitution du signal de réception (RI) en fonction d'une tension de commande (VLC) ajustable au moyen d'un élément de manoeuvre (POTI1), tandis qu'il est prévu un détecteur signal/bruit servant à obtenir, pendant les repos de conversation, une tension complémentaire dépendant du bruit de fond, caractérisé en ce qu'il est prévu un dispositif de traitement logique de signal (V2) qui produit la tension de commande (VLC) destinée au moyen pouvant être commandé, à partir d'une tension de base ajustée au moyen de l'élément de manoeuvre (POTI1) et à partir de la tension complémentaire lissée dans des dispositifs de mémoire analogique (T1, T2).

2. Agencement suivant la revendication 1, caractérisé en ce que le détecteur signal/bruit est réalisé dans le bloc fonctionnel vocal mains libres (FHS) et en ce qu'un signal de sortie, qui contient une information concernant les repos de conversation, et un signal de comparaison, qui constitue, pendant les repos de conversation, une mesure du niveau de bruit de fond, peuvent être prélevés sur des bornes du bloc fonctionnel vocal mains libres (FHS).

3. Agencement suivant la revendication 1, caractérisé en ce que le détecteur signal/bruit est prévu séparément du bloc fonctionnel vocal mains libres (FHS) et en ce qu'un signal de microphone est envoyé à ce détecteur signal/bruit.

4. Agencement suivant la revendication 1, caractérisé en ce que les moyens servant à obtenir la tension complémentaire (VLC) et/ou le dispositif de traitement logique de signal sont intégrés, partiellement ou totalement, dans le bloc fonctionnel vocal mains libres (FHS).

5. Agencement suivant l'une des revendications précédentes, caractérisé en ce que la tension complémentaire est rapportée à une tension de référence (sur VB) produite dans le bloc fonctionnel vocal mains libres (FHS).

6. Agencement suivant l'une des revendications précédentes, caractérisé en ce que la fonction complémentaire automatique peut être coupée.

7. Agencement suivant la revendication 6, caractérisé en ce que la tension complémentaire peut être rangée en mémoire lorsque la fonction complémentaire automatique est coupée.

8. Agencement suivant la revendication 6, caractérisé en ce que, lorsque la fonction complémentaire automatique est coupée, la tension de commande ne dépend plus que de la tension de base.

9. Agencement suivant l'une des revendications 6 à 8, caractérisé en ce que la coupure peut être commandée automatiquement.
